# FASCICULE DE BREVET EUROPEEN

(11) **EP 4 332 002 B1**
(45) Date de publication et mention de la délivrance du brevet: **09.07.2025**
(21) Numéro de dépôt: 23194894.4
(22) Date de dépôt: 01.09.2023
(51) Int. Cl.: B64D 43/00, B64F 5/10, B64D 13/00, H05K 7/20, B64D 13/06

(54) **MODULE AMELIORE DE BAIE AVIONIQUE**
VERBESSERTES MODUL FÜR AVIONIKFENSTER
IMPROVED AVIONICS RACK MODULE

(30) Priorité: 01.09.2022 FR 2208799
(43) Date de publication de la demande: 06.03.2024
(73) Titulaire: Airbus Operations SAS, 31060 Toulouse (FR)
(72) Inventeur: ARMERO, Bernardo, 31060 TOULOUSE (FR)
(74) Mandataire: Cabinet Le Guen Maillet

(56) Documents cités:
- WO-A1-2020/035542
- FR-A1- 2 872 640

## Description

### DOMAINE TECHNIQUE

L'invention concerne le domaine des baies avioniques.

### ETAT DE LA TECHNIQUE ANTERIEURE

Il est connu que les aéronefs modernes embarquent de nombreux éléments avioniques.

Il est précisé que par éléments avioniques, il est entendu des éléments d'électronique ou d'informatique de bord.

D'une manière connue, dans un aéronef, ces éléments peuvent être placés sous le cockpit, dans une soute dédiée à cet usage et appelée soute avionique.

Il est aussi connu que les éléments avioniques (comme la plupart des éléments électroniques et informatiques) dissipent de la chaleur en fonctionnant. Il est donc nécessaire de refroidir les éléments avioniques.

D'une manière connue, les éléments avioniques sont fixés sur des baies avioniques qui intègrent des flux de refroidissement.

Ainsi, il est connu d'avoir des baies intégrant un flux d'air froid pulsé sur les éléments avioniques et un flux d'aspiration d'air réchauffé. Il est classique d'avoir un tel flux de réfrigération directement intégré dans la baie. Le flux peut par exemple circuler dans des étagères de la baie avionique et l'air peut y être diffusé ou capté par des perforations ou micro-perforations dans les étagères.

Ces systèmes de refroidissement intégrés dans la baie avionique sont efficaces. Cependant les baies avioniques intégrant ce type de flux de refroidissement sont complexes à assembler et à installer dans une soute avionique, généralement exigüe. Le document FR 2872640 A1 décrit un meuble destiné à l'intégration d'équipement électrique dans un avion comportant une ossature portant des étagères sur lesquelles sont montés les équipements. L'ossature comprend deux panneaux latéraux parallèles reliés à plusieurs niveaux par deux longerons horizontaux, chaque étagère comprend deux plateaux en matériau composite, à savoir un plateau inférieur en forme de cuvette parallélépipédique dont les deux bords longitudinaux sont équipés de rebords longitudinaux horizontaux destinés à venir prendre appui sur deux longerons de l'ossature, le fond de ce plateau étant perforé, et un plateau supérieur plein, comportant deux rebords longitudinaux, destinés à prendre appui sur les rebords du plateau inférieur, les deux plateaux délimitant un volume destiné à être relié à un réseau de ventilation. Le document DE 2537295 A1 décrit un système de refroidissement par air adaptable à entraînement central est destiné aux armoires électroniques contenant des plateaux de cartes de circuits imprimés, avec un seul mécanisme central d'entraînement de l'air. Un conduit d'air entrant est prévu sous une rangée ou une banque entière d'armoires entre lesquelles se trouve une colonne verticale cloisonnée vers le haut à travers laquelle l'air est dirigé. A chaque niveau de plateau dans l'armoire se trouve un évent réglable par lequel l'air passe, traverse latéralement l'armoire en refroidissant le circuit, passe par un évent similaire et remonte par une colonne similaire jusqu'au sommet de l'armoire. Il est alors collecté dans un conduit de retour et renvoyé vers l'unité de commande. Les évents réglables permettent différents degrés de refroidissement à différents niveaux dans les armoires.

Dans ce contexte, il est nécessaire de fournir un système permettant d'assembler aisément une baie avionique tout en garantissant un refroidissement optimal des éléments avioniques disposés sur la baie avionique.

### EXPOSE DE L'INVENTION

A cet effet, selon un premier aspect, il est proposé un module de baie avionique, le module comprenant deux étagères et une colonne, la colonne reliant les deux étagères, le module comprenant un premier flux d'air et un deuxième flux d'air circulant chacun dans la colonne et dans les étagères pour refroidir au moins un élément avionique. Chacune des deux étagères comprend (i) un plateau s'étendant selon un plan transversal et destiné à supporter un élément avionique et comprend (ii) une demi-coque s'étendant selon un plan longitudinal sécant du plan transversal et étant destinée à être assemblée à une autre demi-coque de l'autre étagère dudit module, pour former la colonne.

Ainsi, l'assemblage de deux étagères permet de former aisément un module. De plus, la colonne formée par l'assemblage de deux étagères a une double fonction de soutien mécanique et de circulation d'air. Le module proposé permet donc d'assembler aisément une baie avionique tout en garantissant un refroidissement optimal des éléments avioniques disposés sur cette baie avionique.

Selon une disposition particulière, chaque demi-coque présente un panneau de montant assemblé à chaque plateau, ledit panneau de montant étant agencé dans le plan longitudinal.

Selon une disposition particulière, chaque demi-coque présente une portion de conduit fixée sur le panneau de montant et s'étendant selon une direction longitudinale.

Selon une disposition particulière, lorsque deux demi-coques sont assemblées, les portions de conduit de chaque demi-coque sont juxtaposées et parallèles.

Selon une disposition particulière, chaque plateau comprend un premier canal interne débouchant par une première ouverture dans le panneau de montant et comprend un deuxième canal débouchant par une deuxième ouverture dans le panneau de montant.

Selon une disposition particulière, la première ouverture est positionnée dans la portion de conduit.

Selon une disposition particulière, la deuxième ouverture est juxtaposée à la première ouverture de sorte à être en regard de la portion de conduit d'une autre demi-coque lorsque deux demi-coques sont assemblées.

Selon une disposition particulière, chaque portion de conduit présente une troisième ouverture agencée en regard de la deuxième ouverture d'un panneau de montant lorsque deux demi-coques sont assemblées, pour permettre une circulation fluidique entre la troisième ouverture et la deuxième ouverture.

Selon une disposition particulière, chaque demi-coque comprend des moyens de fixation à une l'autre demi-coque.

Selon un autre aspect, il est proposé une baie avionique comprenant plusieurs modules tels que précités.

Selon un autre aspect, il est proposé un aéronef comprenant au moins une baie avionique telle que précédemment décrite.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] est une représentation en perspective d'un module de baie avionique ;
[Fig. 2] est une représentation en perspective de l'une des étagères du module de baie avionique déjà représenté sur la Fig. 1 ;
[Fig. 3] est une représentation schématique de dessus du module de baie avionique représenté sur les Fig.1 et Fig. 2 ;
[Fig. 4] est une représentation schématique d'une circulation d'air dans le plateau de l'une des étagères du module de baie avionique ;
[Fig. 5] illustre schématiquement une première phase de fixation des deux étagères du module de baie avionique ;
[Fig. 6] illustre schématiquement une deuxième phase de fixation des deux étagères du module de baie avionique ;
[Fig. 7] illustre schématiquement une troisième phase de fixation des deux étagères du module de baie avionique ;
[Fig. 8] illustre schématiquement un aéronef intégrant la baie avionique ;
[Fig. 9] illustre schématiquement une première phase de fixation des deux étagères du module de baie avionique dans la soute avionique de l'aéronef ;
[Fig. 10] illustre schématiquement une deuxième phase de fixation des deux étagères du module de baie avionique dans la soute avionique de l'aéronef ;
[Fig. 11] illustre schématiquement une troisième phase de fixation des deux étagères du module de baie avionique dans la soute avionique de l'aéronef ; et
[Fig. 12] illustre schématiquement une quatrième phase de fixation des deux étagères du module de baie avionique dans la soute avionique de l'aéronef ;

### EXPOSE DETAILLE DE MODES DE REALISATION

### Module de baie avionique

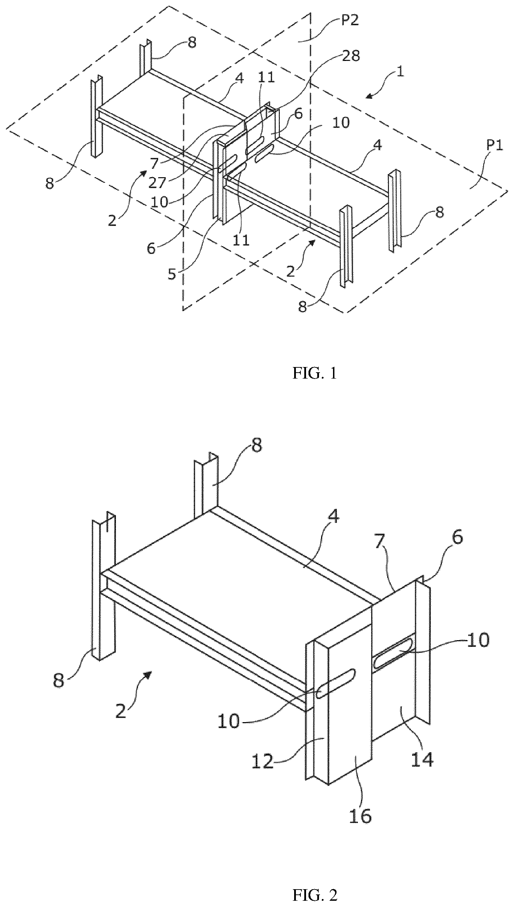

En référence à la Fig. 1, il est proposé un module 1 de baie avionique 50 (non référencée sur la Fig. 1), le module 1 comprend deux étagères 2 et une colonne 5. La colonne 5 relie les deux étagères 2.

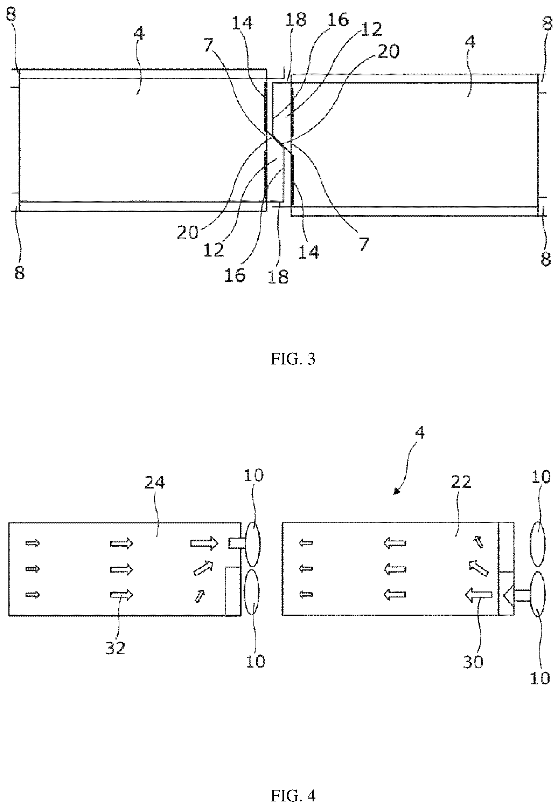

Le module 1 comprend un premier flux d'air permettant la circulation d'un premier flux d'air 30 et un deuxième flux d'air permettant la circulation d'un deuxième flux d'air 32 (représentés sur la Fig. 4). Le premier flux d'air et le deuxième flux d'air 32 circulent chacun dans la colonne 5 et dans les étagères 2 pour refroidir au moins un élément avionique disposé sur le module de baie avionique. Tel que cela sera décrit ultérieurement, le premier flux d'air 30 est un flux dit d'air froid qui est pulsé. En d'autres termes l'air froid est envoyé, poussé, pulsé, dans le premier flux d'air 30. Le deuxième flux d'air 32 est un flux dit d'air chaud qui est aspiré. Plus précisément l'air chaud est de l'air qui s'est réchauffé au contact d'éléments avioniques et qui est extrait du module de baie avionique.

Selon une disposition particulière, la colonne 5 comprend deux cheminées, une première cheminée 27 adaptée pour permettre la circulation du premier flux d'air 30, et une deuxième cheminée 28 adaptée à la circulation du deuxième flux d'air 32. Il est précisé que la première cheminée 27 et la deuxième cheminée 28 sont isolées l'une de l'autre de sorte que le premier flux d'air 30 circulant dans la première cheminée 27 ne communique pas (ne se mélange pas) avec le deuxième flux d'air 32 circulant dans la deuxième cheminée 28.

Chacune des deux étagères 2 comprend (i) un plateau 4 s'étendant selon un plan transversal P1 et destiné à supporter un élément avionique et comprend (ii) une demi-coque 6 s'étendant selon un plan longitudinal P2 sécant du plan transversal et étant destinée à être assemblée à une autre demi-coque 6 de l'autre étagère 2 dudit module 1, pour former la colonne 5 comprenant la première cheminée 27 et la deuxième cheminée 28.

Ainsi, d'une manière particulièrement avantageuse, le module 1 comprend deux étagères 2 qui sont assemblées l'une à l'autre. L'assemblage des deux demi-coques 6 des deux étagères 2 forme la colonne 5 centrale du module 1 de sorte que les deux étagères 2 suffisent pour former un module 1 robuste et permettant une circulation d'air (tel que cela sera développé ci-après).

### Etagère du module

En référence à la Fig. 2, chaque étagère 2 comprend un plateau 4 qui s'étend selon le plan transversal P1.

D'une manière particulièrement avantageuse, le plateau 4 comprend deux faces planes présentant chacune des perforations ou des micro-perforations. Les perforations sont adaptées pour permettre une diffusion (ou expulsion) du premier flux d'air 30 (air froid) et une aspiration du deuxième flux d'air 32 (air chaud).

Tel que schématisé sur la Fig. 4, le plateau 4 comprend deux canaux internes 22 et 24 qui sont positionnés entre les deux faces du plateau. Le premier canal interne 22 est adapté pour la circulation du premier flux d'air 30 et le deuxième canal interne 24 est adapté pour la circulation du deuxième flux d'air 32. Tel que cela sera détaillé ci-après, le premier canal interne et le deuxième canal interne débouchent chacun à l'extérieur du plateau 4, dans la demi-coque 6, pour être reliés à la colonne 5. Selon une disposition particulière, le premier canal interne 22 et le deuxième canal interne 24 sont séparés par une paroi isolante (non représentée). La paroi isolante peut être une paroi creuse comprenant un volume d'air, la paroi isolante peut aussi comprendre de la fibre de verre. Selon un mode de réalisation particulier, la paroi isolante présente une épaisseur supérieure ou égale à 8 millimètres. Selon une disposition préférée, la paroi isolante présente une épaisseur supérieure ou égale à 10 millimètres.

Comme indiqué précédemment, chaque étagère 2 comprend le plateau 4 et la demi-coque 6.

La demi-coque 6 de chaque étagère 2 comprend un panneau de montant 7 qui s'étend dans le plan longitudinal P2.

Selon une disposition particulière, le panneau de montant 7 est perpendiculaire au plateau 4. En d'autres termes, selon cette disposition, le plan longitudinal P2 est perpendiculaire au plan transversal P1.

Tel que cela sera décrit ci-après, le panneau de montant 7 opère une fonction de canalisation des flux d'air (premier flux d'air et deuxième flux d'air) en formant une première cheminée 27 et une deuxième cheminée 28, et opère une fonction de soutien du plateau 4 et des éléments avioniques qui peuvent être positionnés sur le plateau 4.

En outre, chaque demi-coque 6 présente une portion de conduit fermé 12 fixée sur le panneau de montant 7 et s'étendant selon une direction longitudinale. Ainsi, tel que représenté sur la Fig. 2, chaque demi-coque 6 comprend aussi une portion de conduit fermé 12 qui est fixée sur le panneau de montant 7. La portion de conduit fermé 12 s'étend selon une direction longitudinale perpendiculaire au plan transversal P1 dans lequel s'étend le plateau 4. Lorsque deux demi-coques 6 sont assemblées, les portions de conduit fermé 12 forment la première cheminée 27 et la deuxième cheminée 28.

Tel que schématisé sur la Fig. 3, la portion de conduit fermé 12 peut présenter une section en trapèze rectangle. Une première paroi 16 de la portion de conduit fermé 12 est parallèle au panneau de montant 7. Une deuxième paroi 18 de la portion de conduit fermé 12 relie la première paroi 16 de la portion de conduit fermé 12 au panneau de montant 7. La deuxième paroi 18 de la portion de conduit fermé 12 est perpendiculaire au panneau de montant 7 et à la première paroi 16 de la portion de conduit fermé 12.

Une troisième paroi 20 de la portion de conduit fermé 12 relie la première paroi 16 de la portion de conduit fermé 12 au panneau de montant 7. La troisième paroi 20 de la portion de conduit 7 est agencée en biais par rapport au panneau de montant 7, à la première paroi 16 de la portion de conduit fermé 12 et la deuxième paroi 18 de la portion de conduit fermé 12. En d'autres termes, la troisième paroi 20 de la portion de conduit fermé 12 est inclinée par rapport au panneau de montant 7 sans être perpendiculaire au panneau de montant 7. Il est précisé qu'une quatrième paroi de la portion de conduit fermé 12 est formée par le panneau de montant 7.

L'inclinaison de la troisième paroi 20 de la portion de conduit fermé 12 est une disposition technique particulièrement avantageuse qui facilite l'assemblage de deux étagères 2.

En outre, la portion de conduit fermé 12 est positionnée sur le panneau de montant 7 de sorte que le panneau de montant 7 présente une zone d'accueil 14 de la portion de conduit fermé 12 d'un autre panneau de montant 7. Ainsi, lorsqu'une première demi-coque 6 est assemblée à une deuxième demi-coque 6, la première portion de conduit fermé 12 de la première demi-coque 6 et la deuxième portion de conduit fermé 12 de la deuxième demi-coque 6 sont juxtaposées et parallèles.

En sus, comme indiqué précédemment, le premier canal et le deuxième canal de chaque plateau débouchent dans le panneau de montant 7 fixé au plateau 4. Le premier canal débouche dans le panneau de montant par une première ouverture 10. Le deuxième canal débouche dans le panneau de montant par une deuxième ouverture 11. La première ouverture est située dans la portion de conduit fermé 12 et la deuxième ouverture 11 est située dans la zone d'accueil 14.

En outre, la portion de conduit présente une troisième ouverture qui est en regard de la première ouverture 10 dans la portion de conduit fermé 12. La troisième ouverture est adaptée pour être en regard de la deuxième ouverture 11 d'un panneau de montant 7 lorsque les deux demi-coques 6 sont assemblées, pour permettre une circulation fluidique entre la troisième ouverture et la deuxième ouverture 11. Cette disposition sera détaillée ci-après.

En outre, chaque demi-coque 6 comprend des moyens d'assemblage à l'autre demi-coque 6. Selon un mode de réalisation, les demi-coques 6 sont vissées.

Par ailleurs, selon le mode de réalisation ici présenté, chaque étagère 2 comprend deux barres de montants 8 fixées au plateau 4. Les barres de montant 8 s'étendent selon une direction longitudinale. Les barres de montant 8 permettent de rigidifier l'étagère 4 et d'assurer une fonction de soutien mécanique lorsque le module 1 est assemblé.

### Procédé d'assemblage

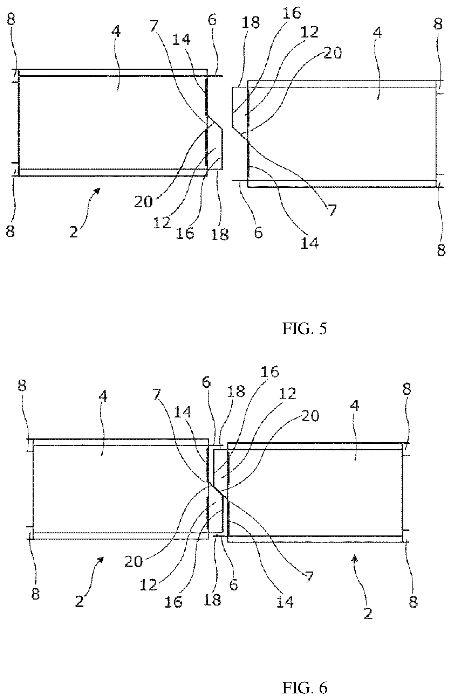

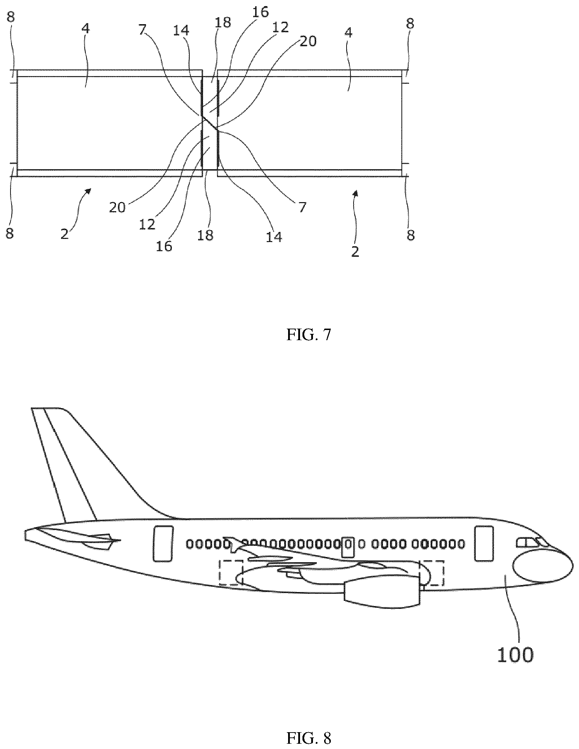

En référence aux figures 5 à 7, le module 1 est assemblé en accouplant deux demi-coques 6 de deux étagères 2 distinctes. Tel que schématisé sur les figures 5 à 7, la troisième paroi 20 de chaque portion de conduit fermé 12 permet de guider l'assemblage en ayant une fonction de rampe de glissière. En d'autres termes, lors de l'assemblage, les troisièmes parois 20 des deux portions de conduits 12 glissent l'une contre l'autre jusqu'à ce que les deux portions de conduit 12 soient chacune positionnées en butée contre la zone d'accueil 14 de la demi-coque 6 correspondante.

### Fonctionnement du refroidissement

Comme indiqué précédemment, le module 1 comprend deux flux d'air permettant la circulation de deux flux d'air 30 et 32. Lorsque le module est assemblé, l'air froid (premier flux d'air 30) est injecté au travers de l'une des portions de conduit 12 du module 1. L'air froid passe par les ouvertures dans la portion de conduit fermé 12 pour se répandre dans le premier canal de chaque plateau 4. Puis l'air froid est diffusé au travers des perforations des faces des plateaux 4.

Parallèlement, l'air chaud (deuxième flux d'air 32) est aspiré à partir des perforations des faces des plateaux 4. L'air chaud circule ensuite dans le deuxième conduit de chaque plateau 4 puis débouche via les ouvertures dans la deuxième portion de conduit fermé 12 du module d'où il est aspiré puis refroidi par un système de refroidissement avant d'être réinjecté dans la première portion de conduit fermé 12.

Ce système permet de garantir un refroidissement optimal d'éléments avioniques positionnés sur le module 1, tout en garantissant une extraction d'air chaud situé sous le module 1.

### Baie avionique

Selon un autre aspect, il est proposé une baie avionique 50 comprenant plusieurs modules 1 assemblés les uns aux autres.

D'une manière particulièrement avantageuse, les étagères 2 des différents modules 1 peuvent être préassemblées en deux séries distinctes 51 et 52. Dans chaque série 51 et 52, les étagères 2 sont assemblées selon la direction longitudinale. Puis les deux séries 51 et 52 sont assemblées l'une à l'autre en assemblant les demi-coques 6 de chaque module 1.

### Aéronef

Selon un autre aspect, il est proposé un aéronef 100 comprenant la baie avionique 50.

Typiquement la baie avionique 50 peut être assemblée et fixée dans une soute avionique 120 de l'aéronef 100.

Divers éléments avioniques peuvent être positionnés sur la baie avionique 50.

### Procédé d'intégration dans la soute avionique

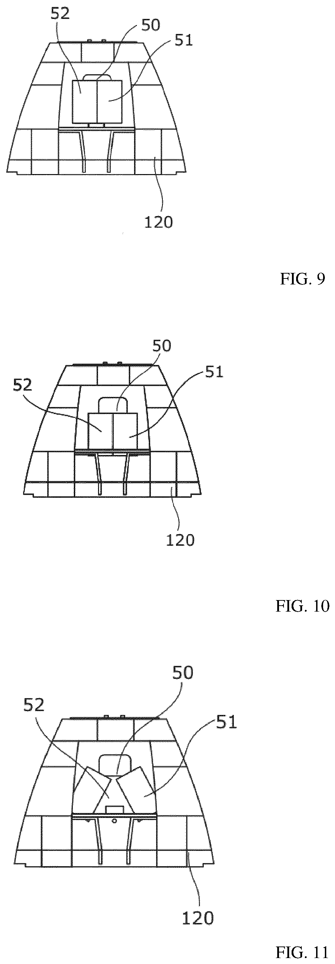

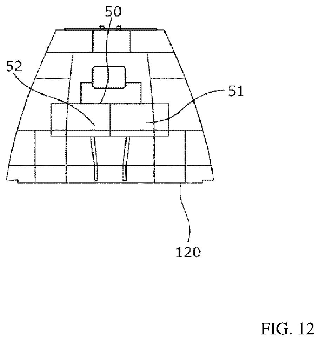

En référence aux figures 9 à 12, lors de l'intégration dans la soute avionique 120, les deux séries 51 et 52 d'étagères 2 sont introduites dans la soute avionique 120, par exemple au moyen d'un système élévateur. Les étagères 2 des deux séries 51 et 52 peuvent être juxtaposées de sorte que les demi-coques 6 soient toutes dans un même plan. Puis, les deux séries 51 et 52 sont pivotées l'une par rapport à l'autre pour assembler les demi-coques 6 correspondantes de chaque module 1.

Ainsi, ce mode d'assemblage et d'intégration permet avantageusement d'intégrer et d'assembler aisément une baie avionique 50 dans une soute avionique 120.

## Revendications

1. Module (1) de baie avionique, le module (1) comprenant deux étagères (2) et une colonne (5), la colonne (5) reliant les deux étagères (2), le module (1) comprenant un premier flux d'air et un deuxième flux d'air circulant chacun dans la colonne (5) et dans les étagères (2) pour refroidir au moins un élément avionique, chacune des deux étagères (2) du module (1) comprenant un plateau (4) s'étendant selon un plan transversal (P1) et destiné à supporter un élément avionique, le module (1) étant **caractérisé en ce que** chacune des deux étagères (2) comprend une demi-coque (6) s'étendant selon un plan longitudinal (P2) sécant du plan transversal (P1) et étant destinée à être assemblée à une autre demi-coque (6) de l'autre étagère (2) dudit module (1), pour former la colonne (5).

2. Module (1) selon la revendication 1, dans lequel chaque demi-coque (6) présente un panneau de montant (7) assemblé à chaque plateau (4), ledit panneau de montant (7) étant dans le plan longitudinal (P2).

3. Module (1) selon la revendication 2, dans lequel chaque demi-coque (6) présente une portion de conduit fermé (12) fixée sur le panneau de montant (7) et s'étendant selon une direction longitudinale.

4. Module (1) selon la revendication 3, dans lequel lorsque deux demi-coques (6) sont assemblées, les portions de conduit fermé (12) de chaque demi-coque (6) sont juxtaposées et parallèles.

5. Module (1) selon l'une quelconque des revendications précédentes, dans lequel chaque plateau (4) comprend un premier canal interne débouchant par une première ouverture (10) dans le panneau de montant (7) et comprend un deuxième canal débouchant par une deuxième ouverture (11) dans le panneau de montant (7).

6. Module (1) selon les revendications 3 et 5 en combinaison dans lequel la première ouverture (10) est positionnée dans la portion de conduit fermé (12).

7. Module (1) selon la revendication 6 dans lequel la deuxième ouverture (11) est juxtaposée à la première ouverture (10) de sorte à être en regard de la portion de conduit fermé (12) d'une autre demi-coque (6) lorsque deux demi-coques (6) sont assemblées.

8. Module (1) selon la revendication 7, dans lequel chaque portion de conduit fermé (12) présente une troisième ouverture agencée en regard de la deuxième ouverture (11) d'un panneau de montant (7) lorsque deux demi-coques (6) sont assemblées, pour permettre une circulation fluidique entre la troisième ouverture et la deuxième ouverture (11).

9. Module (1) selon l'une quelconque des revendications précédentes dans lequel chaque demi-coque (6) comprend des moyens de fixation à l'autre demi-coque (6).

10. Baie avionique (50) comprenant plusieurs modules (1) selon l'une quelconque des revendications 1 à 9.

11. Aéronef (100) comprenant au moins une baie avionique (50) selon la revendication 10.

## Patentansprüche

1. Modul (1) eines Avionikgestellrahmens, wobei das Modul (1) zwei Regale (2) und eine Säule (5) umfasst, wobei die Säule (5) die beiden Regale (2) verbindet, wobei das Modul (1) einen ersten Luftstrom und einen zweiten Luftstrom umfasst, die jeweils in der Säule (5) und in den Regalen (2) zirkulieren, um mindesten ein Avionikelement zu kühlen, wobei jedes der beiden Regale (2) des Moduls (1) einen Boden (4) umfasst, der sich entlang einer Querebene (P1) erstreckt und dazu bestimmt ist, ein Avionikelement zu tragen, wobei das Modul (1) **dadurch gekennzeichnet ist, dass** jedes der beiden Regale (2) eine Halbschale (6) umfasst, die sich entlang einer Längsebene (P2) erstreckt, die die Querebene (P1) schneidet, und dazu bestimmt ist, an eine andere Halbschale (6) des anderen Regals (2) des Moduls (1) montiert zu werden, um die Säule (5) zu bilden.

2. Modul (1) nach Anspruch 1, wobei jede Halbschale (6) ein Stützenpaneel (7) aufweist, das an jeden Boden 4) montiert ist, wobei das Stützenpaneel (7) in der Längsebene (P2) ist.

3. Modul (1) nach Anspruch 2, wobei jede Halbschale (6) einen Abschnitt einer geschlossenen Leitung (12) aufweist, der an dem Stützenpaneel (7) befestigt ist und sich entlang einer Längsrichtung erstreckt.

4. Modul (1) nach Anspruch 3, wobei, wenn zwei Halbschalen (6) montiert sind, die Abschnitte einer geschlossenen Leitung (12) jeder Halbschale (6) nebeneinander liegen und parallel sind.

5. Modul (1) nach einem der vorhergehenden Ansprüche, wobei jeder Boden (4) einen ersten internen Kanal umfasst, der durch eine erste Öffnung (10) in dem Stützenpaneel (7) mündet, und einen zweiten Kanal umfasst, der durch einen zweite Öffnung (11) in dem Stützenpaneel (7) mündet.

6. Modul (1) nach den Ansprüchen 3 und 5 in Kombination, wobei die erste Öffnung (10) in dem Abschnitt einer geschlossenen Leitung (12) positioniert ist.

7. Modul (1) nach Anspruch 6, wobei die zweite Öffnung (11) neben der ersten Öffnung (10) liegt, so dass sie gegenüber dem Abschnitt einer geschlossenen Leitung (12) einer anderen Halbschale (6) liegt, wenn die beiden Halbschalen (6) montiert sind.

8. Modul (1) nach Anspruch 7, wobei jeder Abschnitt einer geschlossenen Leitung (12) eine dritte Öffnung aufweist, die gegenüber der zweiten Öffnung (11) eines Stützenpaneels (7) angeordnet ist, wenn zwei Halbschalen (6) montiert sind, um eine Fluidzirkulation zwischen der dritten Öffnung und der zweiten Öffnung (11) zu ermöglichen.

9. Modul (1) nach einem der vorhergehenden Ansprüche, wobei jede Halbschale (6) Mittel zur Befestigung an der anderen Halbschale (6) umfasst.

10. Avionikgestellrahmen (50), der mehrere Module (1) nach einem der Ansprüche 1 bis 9 umfasst.

11. Luftfahrzeug (100), das mindestens einen Avionikgestellrahmen (50) nach Anspruch 10 umfasst.

## Claims

1. An avionics rack module (1) comprising two shelves (2) and a column (5), the column (5) linking the two shelves (2), the module (1) comprising a first airstream and a second airstream each circulating in the column (5) and in the two shelves (2) to cool at least one avionics element, each of the two shelves (2) of the module (1) comprising a plate (4) extending on a transverse plane (P1) and configured to support the an avionics element, the module being **characterized in that** each of the two shelves (2) comprises a half-shell (6) extending on a longitudinal plane (P2) secant to the transverse plane (P1) and configured to be joined to another half-shell (6) of the other shelf (2) of said module (1) to form the column (5).

2. Module (1) according to claim 1, wherein each half-shell (6) has an upright panel (7) joined to each plate (4), said upright panel (7) being in the longitudinal plane (P2).

3. Module (1) according to claim 2, wherein each half-shell (6) has a closed duct portion (12) fixed to the upright panel (7) and extending in a longitudinal direction.

4. Module (1) according to claim 3, wherein when two half-shells (6) are joined, the closed duct portions (12) of each half-shell (6) are juxtaposed and parallel.

5. Module (1) according to any of the preceding claims, wherein each plate (4) comprises a first internal channel emerging through a first aperture (10) in an upright panel (7) and a second channel emerging by a second aperture (11) in an upright panel (7).

6. Module (1) according to claims 3 and 5 in combination, wherein the first aperture (10) is positioned in the closed duct portion (12).

7. Module (1) according to claim 6, wherein the second aperture (11) is juxtaposed to the first aperture (10) so as to be facing the closed duct portion (12) of another half-shell (6) when two half-shells (6) are joined.

8. Module (1) according to claim 7, wherein each closed duct portion (12) has a third aperture arranged facing the second aperture (11) of an upright panel (7) when two half-shells (6) are joined, to allow a fluidic circulation between the third aperture and the second aperture (11).

9. Module (1) according to any of the preceding claims, wherein each half-shell (6) comprises means for fixing to the other half-shell (6).

10. An avionics rack (50) comprising a plurality of the avionics rack module (1) according to any of claims 1 to 9.

11. An aircraft comprising at least one avionics rack (50) according to claim 10.
